# EUROPÄISCHE PATENTSCHRIFT

(11) **EP 3 039 718 B1**
(45) Veröffentlichungstag und Bekanntmachung des Hinweises auf die Patenterteilung: **22.04.2020**
(21) Anmeldenummer: 14777014.3
(22) Anmeldetag: 27.08.2014
(51) Int. Cl.: H01L 27/142

(54) **TEILTRANSPARENTE DÜNNSCHICHTSOLARMODULE**
PARTLY-TRANSPARENT THIN-FILM SOLAR MODULE
MODULES SOLAIRES À COUCHES MINCES EN PARTIE TRANSPARENTES

(30) Priorität: 30.08.2013 CN 201310613095
(43) Veröffentlichungstag der Anmeldung: 06.07.2016
(73) Patentinhaber: China Triumph International Engineering Co., Ltd., Shanghai 200063 (CN); CTF Solar GmbH, 01099 Dresden (DE)
(72) Erfinder: RICHTER, Hilmar, 61194 Niddatal (DE); KIESEWETTER, Tobias, Konstanz 78462 (DE); PENG, Shou, Shanghai (CN)
(74) Vertreter: Kailuweit & Uhlemann Patentanwälte Partnerschaft mbB
(86) Internationale Anmeldenummer: PCT/EP2014/068192
(87) Internationale Veröffentlichungsnummer: WO 2015/028519

(56) Entgegenhaltungen:
- EP-A2- 1 638 150
- GB-A- 2 446 838
- JP-A- 2000 223 727
- JP-A- 2003 305 577
- US-A- 4 795 500
- US-A- 5 334 259
- US-A1- 2006 112 987
- US-A1- 2007 251 566
- US-A1- 2009 151 783
- US-A1- 2011 017 280
- US-A1- 2012 125 411
- US-A1- 2012 204 933
- US-A1- 2012 291 853
- TAKEOKA A ET AL: "DEVELOPMENT AND APPLICATION OF SEE-THROUGH A-SI SOLAR CELLS", SOLAR ENERGY MATERIALS AND SOLAR CELLS, ELSEVIER SCIENCE PUBLISHERS, AMSTERDAM, NL, Bd. 29, Nr. 3, 1. April 1993 (1993-04-01), Seiten 243-252, XP000355684, ISSN: 0927-0248, DOI: 10.1016/0927-0248(93)90039-6

## Beschreibung

Die Erfindung betrifft Dünnschichtsolarmodule, bei denen durch gezielte Entfernung bestimmter Teile der nicht bzw. nur sehr schwach transparenten, photovoltaisch aktiven Fläche eine gewollte Teiltransparenz für das auffallende Licht erreicht wird.

Unter Transparenz wird im Folgenden die Durchlässigkeit für Licht im sichtbaren Spektralbereich (380 nm bis 780 nm), bezogen auf die gesamte untersuchte Fläche, verstanden. Explizit heißt dies, dass die untersuchte Fläche (bspw. ein Solarmodul) stark lichtundurchlässige oder sogar völlig lichtundurchlässige und stärker lichtdurchlässige Bereiche aufweisen kann. Teiltransparenz bedeutet in diesem Zusammenhang, dass die betrachtete Fläche für einen Teil des einfallenden Lichtes transparent ist.

Bei der zukünftigen Energieerzeugung werden Solarzellen eine bedeutende Rolle spielen. Insbesondere Dünnschichtsolarmodule haben dabei Vorteile im Hinblick auf geringen Materialverbrauch und erleichterte Massenproduktion. Derartige Solarmodule sind aus amorphen oder polykristallinen Halbleitermaterialien aufgebaut, die sich auf großflächigen Substraten, insbesondere Glassubstraten, kostengünstig abscheiden lassen. Die wichtigsten Vertreter sind Solarmodule auf der Basis von Cadmiumsulfid-Cadmiumtellurid (CdS/CdTe), Kupfer-Indium-Diselenid (CIS-CIGS) oder amorphem Silizium (a-Si).

Dünnschichtsolarmodule bestehen aus mehreren, auf dem Substrat sukzessive abgeschiedenen und ggf. weiterbehandelten Schichten.

Bei den Dünnschichtmodulen mit sog. "Superstrat"-Konfiguration werden vom Substrat (meist Glas) aus beginnend die transparente Frontkontaktschicht, die nicht oder nur sehr schwach transparenten, photovoltaisch aktiven Halbleiterschichten und die Rückkontaktschicht abgeschieden. Bei der überwiegenden Mehrheit der Solarzellen nach dem Stand der Technik ist die Rückkontaktschicht nicht transparent. Es sind jedoch auch Bauweisen mit transparenten Rückkontaktschichten bekannt.

Bei den Dünnschichtmodulen mit sog. "Substrat"-Konfiguration werden vom Substrat aus beginnend die generell nicht transparente Rückkontaktschicht, die nicht transparenten, photovoltaisch aktiven Halbleiterschichten und die transparente Frontkontaktschicht abgeschieden. Bei der Frontkontaktschicht kommen in der Regel transparente leitfähige Oxide (TCO, transparent conductive oxide), z.B. zinndotiertes Indiumoxid (ITO), fluordotiertes Zinnoxid (FTO) oder aluminiumdotiertes Zinkoxid (AZO) sowie stannatartige Verbindungen, z.B. Cadmiumstannat (Cd₂(SnO₄), zur Anwendung.

Die photovoltaische Umwandlung von Sonnenenergie in elektrische Energie bewirkt bei den Solarzellen nach dem Stand der Technik typischerweise Spannungen von unter 1 Volt. Um technisch verwertbare Spannungen zu erhalten, müssen daher mehrere einzelne Solarzellen in Reihe geschaltet werden. Dies erfolgt bei Dünnschichtsolarmodulen vorzugsweise dadurch, dass die aktive Fläche des Solarmoduls in einzelne, streifenförmige Solarzellen unterteilt wird. Die Unterteilung erfolgt durch sogenannte Strukturierungsstreifen, wobei ein jeder Strukturierungsstreifen vorzugsweise aus drei eng benachbarten Strukturierungsschnitten besteht. In einer bevorzugten Ausführungsform durchtrennt jeder Teilschnitt jeweils nur bestimmte Einzelschichten der Schichtfolge des Solarmoduls. Durch geeignete Anordnung der Teilschnitte zueinander und ggf. geeignete Füllung der Strukturierungsschnitte mit leitfähigem oder isolierendem Material wird erreicht, dass der Rückkontakt der einen Solarzelle in Kontakt mit der Frontkontaktschicht der nachfolgenden Solarzelle kommt und Front- und Rückkontakt jeweils vor bzw. hinter der Kontaktstelle durchtrennt sind, woraus sich die serielle Verschaltung dieser Solarzellen ergibt. Man spricht bei diesem Prozess auch von Strukturierung. Entsprechend weist ein Dünnschichtsolarmodul gemäß dem Stand der Technik mehrere einzelne Solarzellen auf, die sich vorzugsweise von einem Rand zum anderen Rand des Solarmoduls (bzw. bis zu den entschichteten Rändern des Solarmoduls) erstrecken. Die einzelnen streifenförmigen Solarzellen sind durch die Strukturierungsstreifen voneinander getrennt und seriell miteinander verschaltet. Zur Strukturierung sind aus dem Stand der Technik verschiedene Verfahren bekannt, bei denen in der Regel im Bereich der Strukturierungsstreifen in Form einzelner strukturierungsschnitte die Beschichtung ganz oder teilweise entfernt wird. Es handelt sich dabei z.B. um mechanische Verfahren, Laserbearbeitungsverfahren, Pastenschreibmethoden oder Lift-off-Techniken (vgl. DE 37 12 589 A1 und DE 43 24 318 C1). Die Strukturierungsstreifen verlaufen bevorzugt parallelzueinander.

Ein wesentlicher Aspekt bei der photovoltaischen Energieerzeugung ist der Flächenbedarf zum Aufstellen der Solarmodule. Aus ökonomisch-ökologischer Sicht sind besonders die Aufständerungen der Solarmodule auf Dächern anzustreben sowie zunehmend die Integration der Solarmodule in Gebäudefassaden, insbesondere Hochhausfassaden.

Für die Anwendung der Solarmodule in Hausfassaden werden diese so konstruiert, dass sie die Funktion einer typischen Fassadenverkleidung erfüllen können. Zusätzlich erzeugen sie vorteilhaft elektrische Energie, die im Haus verwendet oder in das öffentliche elektrische Netz eingespeist werden kann.

Hausfassaden, insbesondere Hochhausfassaden unterliegen im Allgemeinen besonderen architektonischen Anforderungen. Insbesondere sind Bereiche der Fassadenverkleidung teiltransparent zu gestalten. Selbst wenn der Fassadenbereich kein Fenster beinhaltet, sondern lediglich vor einem Funktionsraum, der keinen direkten Tageslichteinfall benötigt, liegt, kann dennoch ein gewisser Lichteinfall wünschenswert sein.

Hier können teiltransparente Fassadenelemente vorteilhaft sein.

Bei herkömmlichen Dünnschicht-Solarmodulen aus dem Stand der Technik ist keine bzw. eine bei weitem zu geringe Teiltransparenz gegeben. Auch die Dünnschichtsolarmodule mit ihrem speziellen Strukturierungsmuster zur seriellen Verschaltung der einzelnen Solarzellenstreifen zeigen keine wesentliche Transparenz, weil die transparenten Strukturschnitte nur eine Breite von zusammen deutlich weniger als 0,1 mm aufweisen und die Strukturierungsbereiche typische Abstände von mehr als 5 mm haben. Die Transparenz der Dünnschichtsolarmodule nach dem Stand der Technik beläuft sich deshalb in der Regel auf deutlich unter 2% des einfallenden Lichtes.

Die US 4,795,500 A beschreibt ein Dünnschichtsolarmodul, das in der oben beschriebenen Superstrat-Konfiguration hergestellt wird. Dabei werden nach dem Abscheiden der metallischen Rückelektrode Löcher in die Rückelektrode oder in die Rückelektrode und die photovoltaisch aktiven Halbleiterschichten geätzt, um die Transparenz des Solarmoduls zu erhöhen. Die Rückseite des Solarmoduls wird anschließend mit einer transparenten Schutzschicht, z.B. aus Kunststoff, verschlossen.

Es stellt sich somit die Aufgabe, teiltransparente Dünnschicht-Solarmodule vorzuschlagen, die neben der Energieerzeugung einen Lichteinfall in den der Lichteinfallseite abgewandten Bereich ermöglichen. Insbesondere soll dabei der optische Eindruck einer geschlossenen, gleichmäßigen und homogenen Fläche möglichst nahe kommen, da die Solarmodule häufig, insbesondere beim Einsatz als Fassadenelemente, auch ästhetischen Anforderungen genügen müssen.

Die Aufgabe wird erfindungsgemäß mit dem Verfahren nach Anspruch 1 gelöst. Vorteilhafte Verfahrensweisen sind in den auf Anspruch 1 rückbezogenen Unteransprüchen offenbart.

Erfindungsgemäß wird die Aufgabe gelöst, indem eine Teiltransparenz des Solarmodul hergestellt wird, indem bei einem Dünnschichtsolarmodul mit einem geeigneten Verfahren frei definierbare Flächenbereiche (transparente Flächenbereiche) des Schichtstapels der Dünnschichtsolarzelle eines solchen Modules, bevorzugt vor der Lamination, gezielt entfernt werden. Die frei definierbaren Flächenbereiche sind bevorzugt derart gestaltet, dass die freien Bereiche mindestens durch alle nicht transparenten Schichten reichen, so dass eine Art Fenster in dem Schichtstapel der Solarzelle entstehen, durch die das Licht hindurchtreten kann.

Das mit dem erfindungsgemäßen Verfahren erzeugte Solarmodul weist eine Mehrzahl frei definierbarer Flächenbereiche auf, die keinen Schichtstapel oder aber nur lichtdurchlässige Schichten des Schichtstapels beinhalten. Der Flächenanteil der frei definierbaren Flächenbereiche liegt bevorzugt zwischen 70% und 5%, besonders bevorzugt zwischen 50% und 10 % und ganz besonders bevorzugt zwischen 40% und 20% der Gesamtfläche des Solarmoduls. Als ganz besonders vorteilhaft hat sich ein Flächenanteil von 30% +-5% erwiesen.

In einer bevorzugten Ausführungsform erfolgt die Ausbildung der frei definierbaren Flächenbereiche, indem an jeder Stelle, die für einen Flächenbereich vorgesehen ist, alle Schichten des Schichtstapels, mindestens aber die lichtundurchlässigen Schichten des Schichtstapels, entfernt werden.

Die nachträgliche Entfernung des Schichtstapels der Dünnschichtsolarzelle in den definierten Flächenbereichen geschieht vorzugsweise mit einem Laserverfahren, wie es auch bei der Strukturierungsaufgabe des Dünnschichtmodules zur Anwendung kommt. Weiterhin bevorzugt sind auch die oben erwähnten mechanischen Verfahren unter Verwendung von Sticheln und Sandstrahleffekten oder speziellen Lift-off-Mechanismen sowie angepassten photolithographischen Verfahren.

In einer weiteren bevorzugten Ausführungsform erfolgt die Ausbildung der frei definierbaren Flächenbereiche, indem die Abscheidung aller Schichten des Schichtstapels, mindestens aber der lichtundurchlässigen Schichten auf die Bereiche außerhalb der frei definierbaren Flächenbereiche beschränkt wird. Geeignet dazu sind technische Vorkehrungen aus dem Stand der Technik, wie bspw. Masken. Bei diesem Vorgehen erfolgt die Abscheidung der Schichten so, dass definierte Flächenbereiche (die frei definierbaren Flächenbereiche) unbeschichtet bleiben und die Teiltransparenz auf diese Weise erzielt wird.

Die Form der frei definierbaren Flächenbereiche kann prinzipiell beliebig sein. Vorzugsweise werden aber einfache geometrische Formen wie Rechtecke, Trapeze, Dreiecke, Polygone oder Kreise zur Anwendung kommen. Die Formen werden so gewählt, dass sie sich möglichst symmetrisch entlang eines durch die Strukturierung vorgegebenen Solarzellenstreifens anordnen lassen. Je breiter die Solarzellenstreifen sind, desto mehr Variationsmöglichkeiten für die Formen ergeben sich. Bevorzugt ist der Flächenanteil der frei definierbaren Flächenbereiche in jedem Solarzellenstreifen eines Solarzellenmoduls gleich groß.

In einer bevorzugten Ausführungsform wird die Transparenz erzeugt, indem die Strukturierungsschnitte breiter ausgeführt werden.

Die frei definierbaren Flächenbereiche sind mit einem farblosen oder farbigen transparenten Kunststoff ausgefüllt, so dass eine zum Abschluss der Rückkontaktschicht ebene Oberfläche entsteht. Durch die Nutzung eines farbigen Kunststoffes können vorteilhafte ästhetische Ausführungsformen des Solarzellenmoduls erreicht werden. Dieses Auffüllen der frei definierbaren Flächenbereiche erfolgt bevorzugt mittels eines photolithografischen Prozesses nach dem Stand der Technik. Als Kunststoffmaterial kommt bspw. PMMA zum Einsatz.

Durch die Entfernung der photovoltaisch aktiven Schichten in den definierten Flächenbereichen wird der Wirkungsgrad des Dünnschichtsolarmodules im idealen Fall nur im Verhältnis der entfernten Fläche zur gesamten photovoltaisch aktiven Fläche reduziert. In diesem Falle werden die Formen der Flächen vorzugsweise so gewählt, dass die erhaltenen photovoltaischen Flächen zwischen den entfernten Flächen eine Rechteckform aufweisen. Dadurch ist gewährleistet, dass die erhaltenen photovoltaisch aktiven Restflächen zwischen zwei benachbarten Strukturierungsschnitten gleich bleibende Breite b und eine Rechteckform haben. Für den in den Flächenbereichen Δx* b Rechteck (Δx - Länge) entlang der rechteckförmigen photovoltaischen Restflächen generierten photovoltaischen Strom steht damit, wie analog schon bei den ursprünglichen Solarzellenstreifen, ein Strompfad konstanter Breite b des Rechteck s zur Verfügung. Treffen alle rechteckförmigen photovoltaisch aktiven Restflächen an den Strukturierungsschnitten immer mit ihrer Breite b des Rechtecks aufeinander, dann entsprechen die elektrischen Gegebenheiten bzgl. Serienwiderstand und Stromdichte dem seriellen Verschaltungsprinzip des ursprünglichen Dünnschichtsolarmodules. Nur der gelieferte Gesamtstrom und damit der Wirkungsgrad sind gemäß dem Verhältnis der entfernten Flächenbereiche zur gesamten photovoltaisch aktiven Fläche reduziert.

Photovoltaisch ideale transparente Flächenbereiche sind daher Rechtecke, die sich über den gesamten Solarzellenstreifen erstrecken und die derart angeordnet sind, dass die photovoltaisch aktive Restfläche pro Solarzellenstreifen für alle Solarzellenstreifen des Dünnschichtsolarmodules gleich ist.

Die Abmessungen der frei definierbaren Flächenbereiche werden abhängig vom vorgesehenen Einsatzbereich der Solarzellenmodule gewählt. Wenn die mit den Solarzellenmodulen bestückte Fläche einen glatten und homogenen Eindruck erwecken soll, sind die frei definierbaren Flächenbereiche sehr klein, so dass sie vom Betrachter aus einer gewissen Entfernung nicht mehr einzeln wahrgenommen werden können. In einer weiteren bevorzugten Ausführungsform bilden die frei definierbaren Flächenbereiche eigene Gestaltungselemente der mit den Solarzellenmodulen zu bestückenden Fläche. Hier sind die Abmessungen dann so groß, dass die Flächenbereiche für den Betrachter sichtbar sind.

Um weitergehende ästhetische und architektonische Bedürfnisse zu erfüllen, sind jedoch komplexere Muster notwendig. So können die photovoltaisch aktiven Restflächen in einer weiteren bevorzugten Ausführungsform parallelogrammartig mit der Breite b des Parallelogramms sein und an den Strukturierungsschnitten nicht über ihre Breite b des Parallelogramms zusammentreffen, sondern seitlich beliebig versetzt angeordnet sein. Kreis- und Ellipsenformen als transparente, photovoltaisch nicht aktive Flächenbereiche sind ebenfalls bevorzugt. Aber auch transparente Trapez- und Dreickformen können je nach Anordnung zu unterschiedlich breiten photovoltaisch aktiven Restflächen führen. Unter solchen Gegebenheiten werden erhebliche zusätzliche Serienwiderstandseffekte generiert, weil die Strompfade länger werden als im ursprünglichen Dünnschichtmodul und die Einschnürungen der Strompfade bei variierender Breite der photovoltaisch aktiven Restflächen zu lokal höheren Stromdichten führen. Im Einzelfall ist zu untersuchen oder rechnerisch zu ermitteln, ob die auftretenden Stromdichten akzeptabel sind oder bspw. durch eine Erhöhung der Materialdicke (Schichtdicke) kompensiert werden können.

Um die oben beschriebenen beeinträchtigenden Serienwiderstandseffekte weitgehend zu vermeiden, wird in einer besonders bevorzugten Verfahrensweise beim Entfernen des Schichtstapels der Dünnschichtsolarzelle der Prozessablauf so gestaltet, dass die leitfähige, transparente Frontkontaktschicht erhalten bleibt. Dadurch, dass auf diese Weise für den, in den photovoltaisch aktiven Restflächen erzeugten photovoltaischen Strom im Bereich der Frontkontaktschicht die ursprünglichen Strompfade des Dünnschichtsolarmodules komplett erhalten werden, werden negative Serienwiderstandseffekte vermieden, weil keinerlei Verlängerungen des Strompfades bzw. unerwünschte lokale Zunahmen der Stromdichte des photovoltaisch erzeugten Stromes auftreten.

Der beschriebene vorteilhafte Effekt ist insbesondere bei der Frontkontaktschicht von Bedeutung, weil der Flächenwiderstand R_{Square,Front} der Frontkontaktschicht in der Regel um bis zu einem Faktor 10 größer ist als der Flächenwiderstand des Rückkontaktes R_{Square,Rück}, der deshalb auch nur im Bereich der photovoltaisch aktiven Restfläche erhalten bleiben muss. Andererseits kann die Dicke der Rückkontaktschicht auch leicht erhöht werden, falls Serienwiderstandseffekte auftreten. Dagegen ist die Dicke der Frontkontaktschicht auf photovoltaische Wirksamkeit optimiert (Transmission des einfallenden Lichtes) und könnte nur unter zusätzlichen Wirkungsgradverlusten dicker ausgeführt werden.

Die Erfindung wird anhand mehrerer Ausführungsbeispiele erläutert.

Die beigefügten Figuren dienen der Erläuterung des Ausführungsbeispiels:

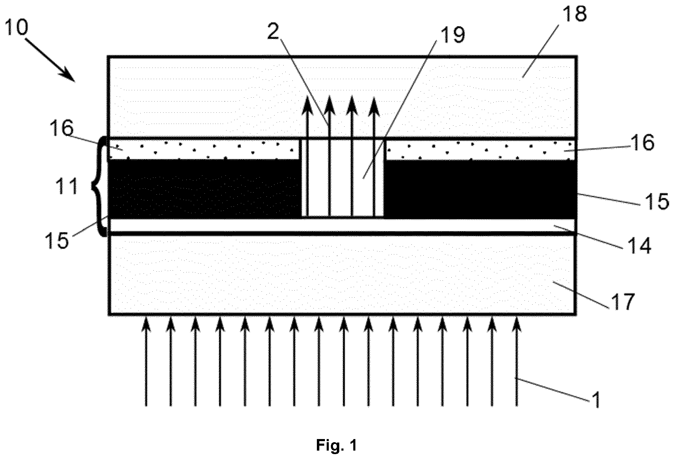

**Fig. 1** zeigt schematisch das erfindungsgemäße Prinzip der Realisierung der Teiltransparenz eines Dünnschichtsolarmoduls 10 im Querschnitt. Die Solarzelle 11 besteht aus dem Schichtstapel der die Schichten
   - transparenter Frontkontakt 14,
   - nicht transparenter CdS/CdTe-Schicht 15 und
   - nicht transparenter Rückkontaktschicht 16 aufweist.

   Die Solarzelle wird auf dem Frontglas 17 abgeschieden. Durch die Entfernung definierter transparenter Bereiche 19 der nicht transparenten Schichten 15 und 16 ergibt sich die gewünschte Teiltransparenz. Der Prozess des Entfernens der definierten, nicht transparenten Schichten 15 und 16 wird bei der hier vorliegenden "Superstrat"- Konfiguration des Dünnschichtsolarmodules 10 so ausgeführt, dass die transparente Frontkontaktschicht 14 erhalten bleibt (Vermeidung zusätzlichen Serienwiderstandes). Anschließend wird das Rückglas 18 wie beim normalen Herstellen des Dünnschichtsolarmodules 10 auflaminiert.

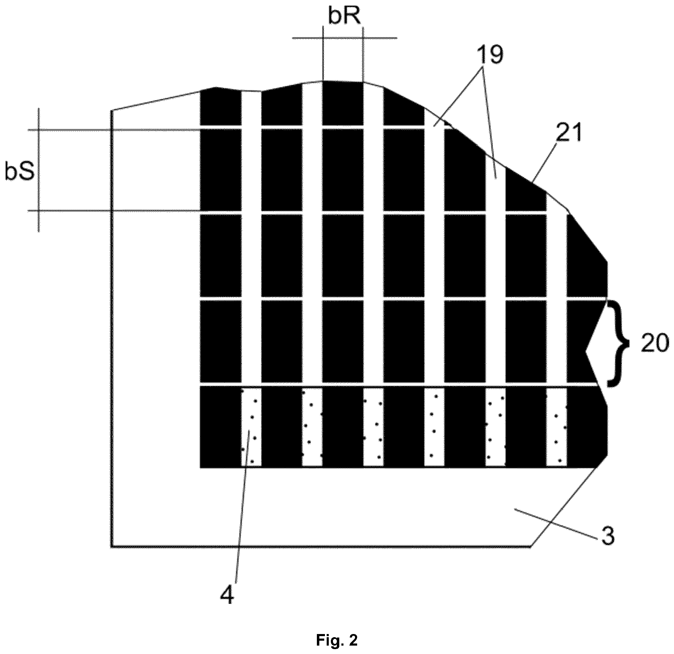

**Fig. 2** zeigt schematisch einen Ausschnitt eines Dünnschichtsolarmodules 10, bei dem aus den Flächen der nicht transparenten Schichten 15 und 16 der Solarzellenstreifen 20 Rechtecke so entfernt werden, dass photovoltaisch aktive Restflächen 21 der Breite b_{Rechteck} erhalten bleiben, deren Länge b_{Streifen} sich über den ganzen Solarzellenstreifen 20 erstreckt. Die photovoltaischen Restflächen 21 stoßen im Bereich der Srukturierungsschnitte benachbarter Solarzellenstreifen 20 über die Breite b_{Rechteck} zusammen.

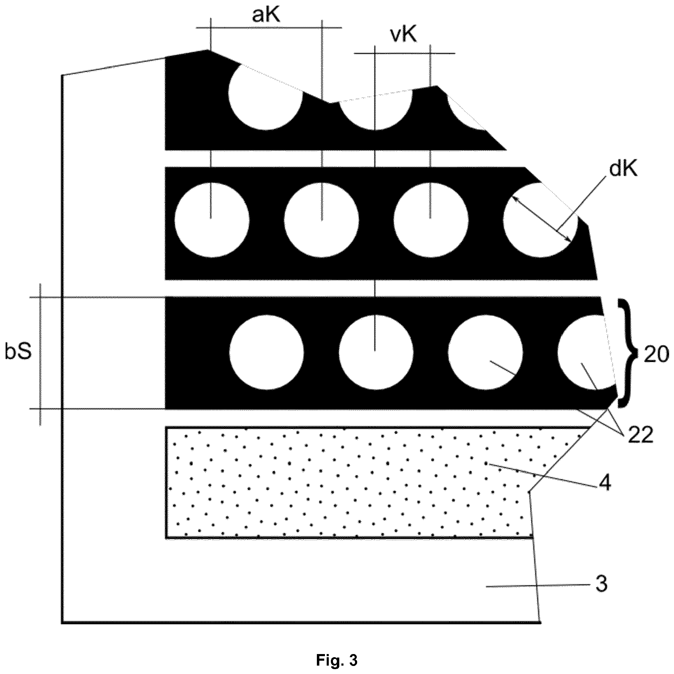

**Fig. 3**: Aus den nicht transparenten Flächen 21 der Solarzellenstreifen 20 des Dünnschichtsolarmodules 10 sind Kreise 22 mit festem Abstand a_{Kreise} und definiertem Durchmesser d_{Kreise} entlang der Mittellinie des Solarzellenstreifens 20 entfernt, wobei gilt: d_{Kreise} < bstreifen . Die Mittelpunkte der Kreise 22 benachbarter Solarzellenstreifen 20 sind jeweils um den halben Abstand aversatz des Mittelpunktabstandes a_{Kreise} zweier Kreise 22 eines Solarzellenstreifens 20 gegeneinander versetzt.

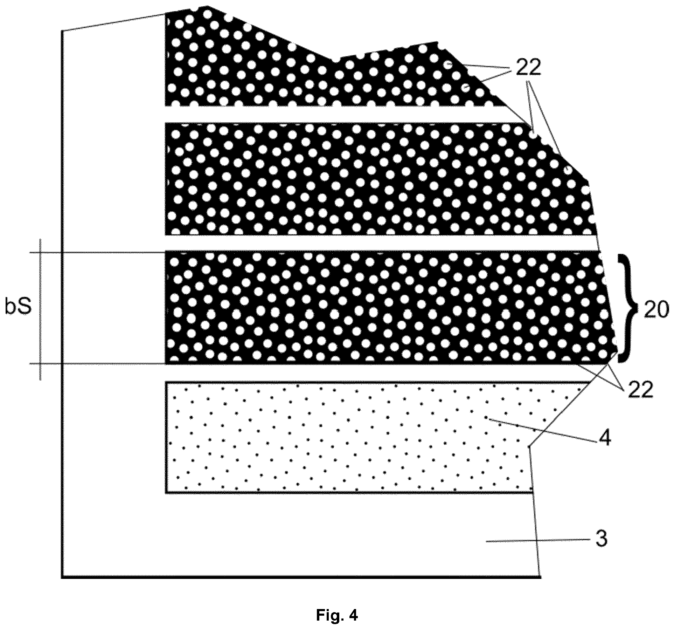

**Fig. 4** zeigt schematisch eine Ausführungsform mit einer Vielzahl kreisförmiger transparenter Flächenbereiche 22, die stochastisch in dem Solarzellenstreifen 20 verteilt sind. Bei dieser Ausführungsform sind die Abmessungen der kreisförmigen transparenten Flächenbereiche 22 sehr viel kleiner, als die Breite b_{Streifen} der Solarzellenstreifen.

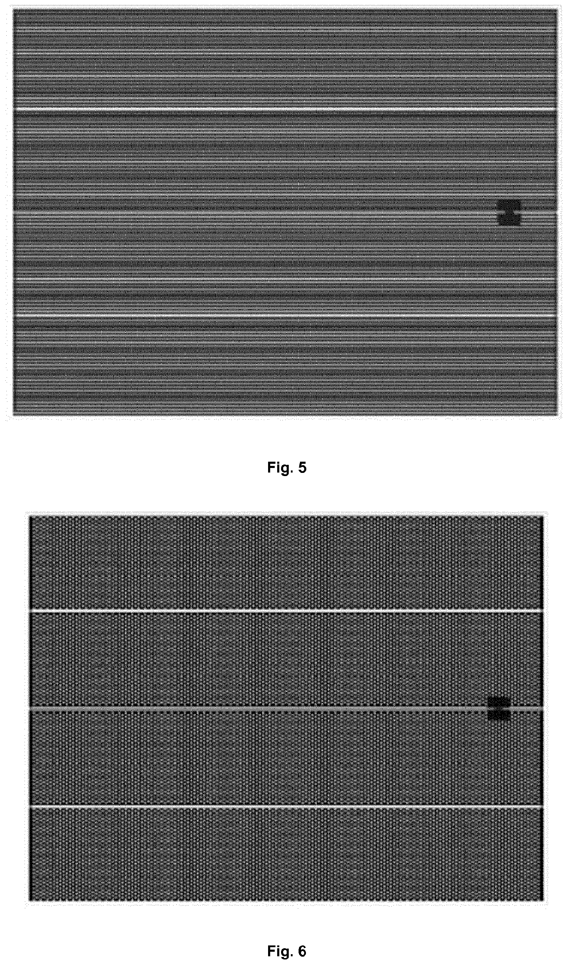

**Fig. 5** zeigt die Realisierung einer "Rechtecktransparenz" von ca. 30% auf der Basis des Dünnschichtmodules 10 des deutschen Geschmacksmusters DM 073 637.
**Fig. 6** zeigt die Realisierung einer "Kreistransparenz" von ca. 30% auf der Basis des Dünnschichtmodules des deutschen Geschmacksmusters DM 073 637. Diese Ausführungsform unterscheidet sich von der in Fig. 4 gezeigten durch eine regelmäßige Anordnung der der kreisförmigen transparenten Flächenbereiche in den Solarzellenstreifen.

### Bezugszeichenliste

- 1: einfallendes Licht
- 2: durch die frei definierbaren Flächenbereiche hindurchtretendes Licht
- 3: entschichteter Rand des Solarzellenmoduls
- 4: Solarzellenstreifen mit Kontaktbus
- 10: Dünnschichtsolarzellenmodul
- 11: Solarzelle
- 14: Frontkontaktschicht
- 15: nicht transparenter CdS/CdTe-Schicht
- 16: nicht transparenter Rückkontaktschicht
- 17: Frontglas
- 18: Rückglas
- 19: transparenter Bereich mit entfernter Schichtstruktur (Flächenbereich)
- 20: Solarzellenstreifen
- 21: nicht transparente Flächen (photovoltaisch aktive Bereiche)
- 22: kreisförmige Flächenbereiche (Kreise)
- bR: Breite b_{Rechteck} der rechteckigen aktiven Restflächen
- bS: Länge bstreifen der rechteckigen aktiven Restflächen
- aK: Abstand a_{Kreise} der kreisförmigen Flächenbereiche (Kreise)
- dK: Durchmesser d_{Kreise} der kreisförmigen Flächenbereiche (Kreise)
- vK: Abstand a_{Versatz} der Mittelpunkte der kreisförmigen Flächenbereiche (Kreise) in benachbarten Streifen

## Patentansprüche

1. Verfahren zur Herstellung eines teiltransparenten Dünnschichtsolarmodul (10) in Substrat-Konfiguration, aufweisend mindestens die folgenden Schritte:
- Bereitstellen eines Substrates (18)
- Aufbringen einer transparenten oder nicht transparenten Rückkontaktschicht (16)
- Aufbringen einer nicht oder nur sehr schwach transparenten photovoltaisch aktiven Halbleiterschicht (15)
- Aufbringen einer transparenten Frontkontaktschicht (14)
- Strukturieren der Schichten mittels parallel zueinander verlaufender Strukturierungsstreifen und Aufteilung der Beschichtung in einzelne in Serie verschaltete Solarzellenstreifen (20)
**dadurch gekennzeichnet, dass**
- aus der Rückkontakt- (16) und der Halbleiterschicht (15) vor dem Abscheiden der Frontkontaktschicht (14) definierte Flächenbereiche (19, 22) entfernt werden
- die entfernten Flächenbereiche (19, 22) mit einem transparenten oder farbig transparenten Kunststoff aufgefüllt und anschließend die transparente Frontkontaktschicht (14) über die transparenten und nicht transparenten Flächenbereiche (19, 22; 21) abgeschieden wird.

2. Verfahren nach Anspruch 1, **dadurch gekennzeichnet, dass** die transparenten Flächenbereiche (19, 22) stochastisch oder regelmäßig auf der Modulfläche angeordnet sind.

3. Verfahren nach einem der vorhergehenden Ansprüche, **dadurch gekennzeichnet, dass** die transparenten Flächenbereiche (19, 22) bevorzugt
- symmetrisch entlang der Solarzellenstreifen (20) angeordnet sind,
- ihre jeweilige Ausdehnung die Breite des Solarzellenstreifens (20) nicht überschreitet,
- die Gesamtfläche der transparenten Flächenbereiche (19, 22) für alle Solarzellenstreifen (20) gleich ist.

4. Verfahren nach einem der vorhergehenden Ansprüche, **dadurch gekennzeichnet, dass** die definierten Flächenbereiche (19, 22) mit entfernter Halbleiter- und Rückkontaktschicht (15, 16) durch beliebig verbreiterte Strukturierungsschnitte erzeugt werden und damit die gewünschte Teiltransparenz realisiert wird.

5. Verfahren nach einem der vorhergehenden Ansprüche, **dadurch gekennzeichnet, dass** die definierten Flächenbereiche (19, 22) mit entfernter Halbleiter- und Rückkontaktschicht (15, 16) im Bereich der Solarzellenstreifen (20) liegen und
- Rechteckform
- Parallelogrammform
- Kreisform
- Dreieckform
- Trapezform
- polygonale Formen
aufweisen.

6. Verfahren nach einem der vorhergehenden Ansprüche, **dadurch gekennzeichnet, dass** die definierten Flächenbereiche (19, 22) in der Halbleiter- und Rückkontaktschicht (15, 16) mit einem
- Laser-Prozess,
- mechanischen Ritz-Prozess,
- Lift-Off-Prozess,
- Ätz-Prozess,
- Sandstrahl-Prozess,
entfernt werden.

## Claims

1. A method for the manufacture of a partially transparent thin-layer solar module (10) in a substrate configuration, comprising at least the following steps:
- providing a substrate (18)
- applying a transparent or opaque back contact layer (16)
- applying a photovoltaically active semiconductor layer (15) which is opaque or only very slightly transparent
- applying a transparent front contact layer (14)
- structuring the layers by means of parallel structuring strips and dividing the coating into individual solar cell strips (20) which are connected in series,
**characterized in that**
- defined surface regions (19, 22) are removed from the back contact layer (16) and the semiconductor layer (15) prior to depositing the front contact layer (14)
- the removed surface regions (19, 22) are filled in with a transparent or coloured transparent plastic and then the transparent front contact layer (14) is deposited over the transparent and opaque surface regions (19, 22; 21).

2. The method as claimed in claim 1, **characterized in that** the transparent surface regions (19, 22) are disposed on the module surface in a random or regular manner.

3. The method as claimed in one of the preceding claims, **characterized in that** the transparent surface regions (19, 22) preferably:
- are disposed symmetrically along the solar cell strips (20),
- do not exceed the width of the solar cell strip (20),
- have the same total area of the transparent surface regions (19, 22) for all of the solar cell strips (20).

4. The method as claimed in one of the preceding claims, **characterized in that** the defined surface regions (19, 22) with the removed semiconductor layer (15) and back contact layer (16) are produced by widening the structuring lines to any extent to produce the desired partial transparency.

5. The method as claimed in one of the preceding claims, **characterized in that** the defined surface regions (19, 22) with the removed semiconductor layer (15) and back contact layer (16) are in the region of the solar cell strips (20) and have the following shape:
- rectangular
- parallelogram
- circular
- triangular
- trapezoidal
- polygonal.

6. The method as claimed in one of the preceding claims, **characterized in that** the defined surface regions (19, 22) in the semiconductor layer (15) and back contact layer (16) are removed by means of a:
- laser process,
- mechanical scoring process,
- lift-off process,
- etching process,
- sandblasting process.

## Revendications

1. Procédé de fabrication d'un module solaire à couche mince partiellement transparent (10) dans une configuration de substrat, présentant au moins les étapes suivantes :
- la préparation d'un substrat (18)
- l'application d'une couche de contact arrière transparente ou non transparente (16)
- l'application d'une couche semi-conductrice (15) à activité photovoltaïque, à transparence nulle ou très faible
- l'application d'une couche de contact avant transparente (14)
- la structuration des couches au moyen de bandes structurantes parallèles les unes aux autres et la division du revêtement en bandes de cellules solaires individuelles connectées en série (20)
**caractérisé en ce que**
- des zones de surface définies (19, 22) sont éliminées de la couche de contact arrière (16) et de la couche semi-conductrice (15) avant le dépôt de la couche de contact avant (14)
- les zones de surface éliminées (19, 22) sont remplies d'un plastique transparent ou transparent coloré, et la couche de contact avant transparente (14) est ensuite déposée sur les zones de surface transparentes et non transparentes (19, 22 ; 21).

2. Procédé selon la revendication 1, **caractérisé en ce que** les zones de surface transparentes (19, 22) sont disposées stochastiquement ou régulièrement sur la surface du module.

3. Procédé selon l'une quelconque des revendications précédentes, **caractérisé en ce que** les zones de surface transparentes (19, 22), de préférence,
- sont disposées symétriquement le long des bandes de cellules solaires (20),
- leur dimension respective ne dépasse pas la largeur de la bande de cellules solaires (20),
- la surface totale des zones de surface transparentes (19, 22) est la même pour toutes les bandes de cellules solaires (20).

4. Procédé selon l'une quelconque des revendications précédentes, **caractérisé en ce que** les zones de surface définies (19, 22) à couche semi-conductrice et couche de contact arrière éliminées (15, 16) sont générées par des sections structurantes élargies à volonté et ainsi la transparence partielle souhaitée est réalisée.

5. Procédé selon l'une quelconque des revendications précédentes, **caractérisé en ce que** les zones de surface définies (19, 22) à couche semi-conductrice et couche de contact arrière éliminées (15, 16) sont situées dans la zone des bandes de cellules solaires (20) et présentent
- une forme rectangulaire
- une forme parallélogrammatique
- une forme circulaire
- une forme triangulaire
- une forme trapézoïdale
- des formes polygonales.

6. Procédé selon l'une quelconque des revendications précédentes, **caractérisé en ce que** les zones de surface définies (19, 22) dans la couche semi-conductrice et la couche de contact arrière (15, 16) sont éliminées à l'aide d'un
- processus laser,
- processus de rainurage mécanique,
- processus de décollage,
- processus de gravure,
- processus de sablage.
